# DEMANDE DE BREVET EUROPEEN

(11) **EP 1 004 919 A1**
(43) Date de publication de la demande: **31.05.2000**
(21) Numéro de dépôt: 99402899.1
(22) Date de dépôt: 22.11.1999
(51) Int. Cl.: G02F 1/025

(54) **Composant optique à base d'amplificateurs optiques à semi-conducteur comportant un nombre réduit d'electrodes indépendantes**

(30) Priorité: 24.11.1998 FR 9814803
(71) Demandeur: ALCATEL, 75008 Paris (FR)
(72) Inventeur: Dagens, Béatrice, 94230 Cachan (FR); Janz, Christopher, 94230 Cachan (FR)
(74) Mandataire: Ballot, Paul

(57) **Abrégé**

L'invention concerne un composant optique à base d'amplificateurs optiques à semi-conducteurs dans lequel le nombre d'électrodes indépendantes est réduit. Le composant comprend différentes régions (1, 2, 3, 4, 5) ayant la même structure verticale dans laquelle un guide d'onde actif (20) est enterré entre des couches tampon inférieure et supérieure. Ces régions comportent chacune des électrodes inférieure et supérieure (10, E₂, E₄) afin d'y injecter des valeurs de densité de courant égales ou différentes. Ce composant est caractérisé en ce qu'au moins une (10) desdites électrodes recouvre plusieurs régions (1, 3, 5) et présente une résistivité distribuée qui est ajustée selon la région considérée.

## Description

L'invention se situe dans le domaine des composants optiques à semi-conducteurs utilisés pour la transmission optique ou le traitement de données numériques optiques.

Elle se rapporte plus particulièrement à tous les composants optiques comportant plusieurs amplificateurs optiques à semi-conducteurs notés par la suite "SOA" (pour "Semiconductor Optical Amplifier" en littérature anglo-saxonne), comme par exemple les convertisseurs de longueurs d'onde, les amplificateurs multi-bras, les interrupteurs tout optique ou encore les multiplexeurs.

Pour simplifier l'exposé de l'invention, on ne parlera, dans la suite, que des convertisseurs de longueur d'onde tout actif, l'objet de l'invention s'étendant, comme cela vient d'être dit, également à tous les composants optiques à base de plusieurs SOA.

Les convertisseurs de longueur d'onde sont utilisés dans le domaine des télécommunications, pour convertir un signal optique transmis, d'une longueur d'onde à une autre longueur d'onde, tout en conservant ses caractéristiques. De tels changements de longueur d'onde sont utilisés en particulier lors du routage des signaux pour résoudre les problèmes de contention.

Dans de tels convertisseurs, les informations sont sous la forme de données binaires représentées par des impulsions modulant une onde porteuse optique. Une valeur binaire est donc déterminée en fonction du niveau d'amplitude (ou de puissance) de l'onde optique modulée.

Une manière courante pour réaliser des convertisseurs de longueur d'onde tout optique consiste à utiliser une structure interférométrique de type Mach-Zehnder ou équivalente.

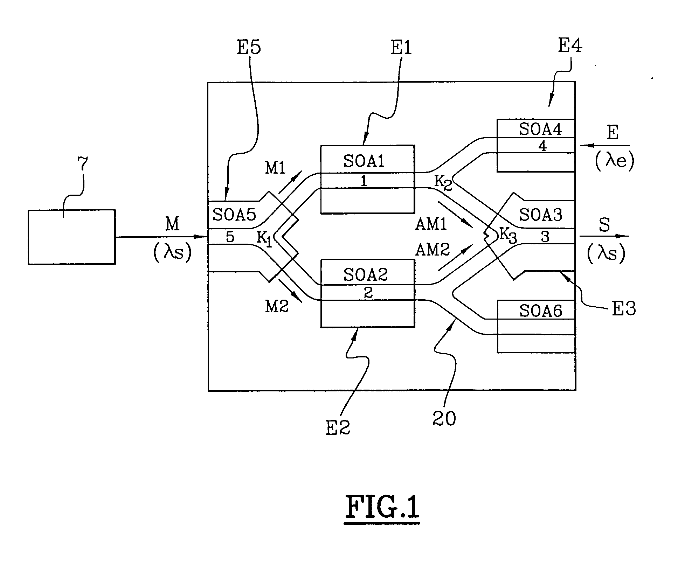

Une telle structure interférométrique est représentée en vue de dessus sur la figure 1. Elle est constituée de deux branches guidantes 1 et 2. Au moins une de ces branches est munie d'un amplificateur optique à semi-conducteur SOA₁. Cependant, en général, on préfère placer un deuxième amplificateur optique à semi-conducteur SOA₂ sur l'autre branche guidante 2 pour des raisons de symétrie. En effet, la présence d'un deuxième amplificateur optique à semi-conducteur SOA₂ permet de conserver sensiblement le même niveau d'amplification dans les deux branches de la structure et par conséquent d'avoir des puissances sensiblement identiques en sortie des branches de l'interféromètre.

Un premier coupleur K₁ permet de coupler une extrémité de chacune de ces branches à un amplificateur optique à semi-conducteur périphérique, encore dénommé amplificateur d'entrée SOA₅. Dans une configuration de fonctionnement contra-directionnel, une source laser externe 7 permet par ailleurs de fournir, à cet amplificateur SOA₅, une onde porteuse de sortie M de longueur d'onde λs.

Un second coupleur K₂ est disposé de façon à coupler l'autre extrémité de la branche 1 à un autre amplificateur optique à semi-conducteur périphérique d'entrée SOA₄. Ce coupleur K₂ permet l'introduction, dans le premier amplificateur SOA₁, d'un signal d'entrée E de longueur d'onde λe ayant été amplifié par l'amplificateur d'entrée SOA₄.

Un troisième coupleur K₃, relié au coupleur K₂, au deuxième amplificateur SOA₂ et à un autre amplificateur optique à semi-conducteur périphérique SOA₃ de sortie, est disposé de façon à fournir un signal de sortie résultant du couplage d'ondes auxiliaires AM₁ et AM₂ fournies respectivement par les premier et deuxième amplificateurs SOA₁ et SOA₂.

Les ondes AM₁ et AM₂ correspondent aux ondes M₁ et M₂ issues du coupleur K₁ amplifiées respectivement par les amplificateurs SOA₁ et SOA₂. Le signal de sortie S, de longueur d'onde λs, est ensuite amplifié par l'amplificateur périphérique de sortie SOA₃. Il résulte d'une interférence constructive ou destructrice des ondes AM₁ et AM₂, selon la différence de phase entre les deux branches 1 et 2 de l'interféromètre.

Un autre amplificateur périphérique SOA₆ est par ailleurs prévu pour respecter la symétrie de la structure et pour permettre le remplacement de l'un des amplificateurs SOA₃ ou SOA₄ dans le cas d'une éventuelle panne.

Des courants d'amplification sont injectés respectivement dans les amplificateurs SOA₁, SOA₂, SOA₃, SOA₄ et SOA₅ au travers d'électrodes E₁, E₂, E₃, E₄ et E₅. Pour faire fonctionner ce type de structure interférométrique, il faut donc utiliser cinq électrodes E₁, E₂, E₃, E₄, E₅ indépendantes, et cinq sources de courant différentes sont nécessaires pour injecter un courant d'amplification sur chaque électrode. Au contraire, dans un composant à structure active/passive équivalente, seules trois sources de courant sont nécessaires pour le faire fonctionner. En effet, dans ce cas, les guides d'ondes 3 et 5 sont passifs, si bien qu'il n'est pas nécessaire de placer des électrodes au-dessus de ces guides pour amplifier le signal.

Le problème que l'invention se propose de résoudre consiste donc à réduire le nombre d'électrodes indépendantes dans les composants tout actif, à base de plusieurs amplificateurs optiques à semi-conducteur, afin de réduire le nombre de sources de courant nécessaires pour les commander. Une telle réduction du nombre d'électrodes permettra de simplifier l'utilisation de ce type de composant et de faciliter son insertion dans les systèmes optiques de télécommunications.

Pour cela, l'invention propose plus particulièrement un composant optique à semi-conducteur, comportant différentes régions ayant la même structure verticale, dans laquelle un guide d'onde actif est enterré entre des couches tampon inférieure et supérieure, lesdites régions comportant des électrodes inférieure et supérieure afin d'y injecter des valeurs de densité de courant égales ou différentes, caractérisé en ce qu'au moins une desdites électrodes recouvre plusieurs régions différentes et présente une résistivité transversale distribuée qui est ajustée selon la région considérée.

Selon une autre caractéristique de l'invention, les électrodes supérieures sont constituées d'une couche de contact sur laquelle est déposée une couche de métallisation, et la résistivité transversale de l'électrode commune à plusieurs régions est ajustée, selon la région considérée, en interrompant localement la couche de contact. Les interruptions locales de cette couche sont par exemple réalisées par gravure sur une largeur au moins identique à celle du guide d'onde actif.

Selon une autre caractéristique de l'invention, la couche de métallisation de l'électrode commune est en outre interrompue localement, par gravure, sur une largeur au moins identique à celle du guide d'onde actif et inférieure à celle de ladite électrode commune.

Selon une autre caractéristique de l'invention, les électrodes supérieures sont constituées d'une couche de contact dopée sur laquelle est déposée une couche de métallisation, et la résistivité transversale de l'électrode commune à plusieurs régions est ajustée, selon la région considérée, en modifiant localement le dopage de la couche de contact. Cette modification locale du dopage est par exemple réalisée par une implantation ionique, sur une largeur au moins identique à celle du guide d'onde actif.

Selon une autre caractéristique de l'invention, le composant optique est un convertisseur de longueur d'onde tout actif.

Selon encore une autre caractéristique de l'invention, ce convertisseur de longueur d'onde comporte une électrode commune à une branche guidante, à une entrée et à une sortie; et deux électrodes de contrôle recouvrant respectivement une autre branche guidante et une autre entrée.

Grâce à l'invention, il est possible de réduire le nombre d'électrodes indépendantes dans un composant optique, notamment dans un composant tout actif. Dans l'exemple d'un convertisseur de longueur d'onde tout actif ce nombre d'électrodes indépendantes est réduit de cinq à trois. Cette réduction du nombre d'électrodes permet de réduire le nombre de sources de courant nécessaires au fonctionnement du composant et, par conséquent, de faciliter l'utilisation du composant et son insertion dans un système optique de télécommunications.

D'autres particularités et avantages de l'invention apparaîtront à la lecture de la description donnée à titre d'exemple illustratif mais non limitatif et faite en référence aux figures annexées qui schématisent :
- la figure 1, déjà décrite, une vue de dessus d'un convertisseur de longueur d'onde tout actif classique,
- la figure 2, une vue de dessus d'un convertisseur de longueur d'onde tout actif réalisé selon la présente invention,
- la figure 3, une vue en coupe longitudinale selon A-A de la figure 2.

L'exemple de convertisseur de longueur d'onde tout actif représenté sur la figure 1 a déjà été décrit pour l'essentiel dans l'introduction ci-dessus. Un tel composant comporte cinq régions différentes 1, 2, 3, 4, 5 correspondant aux deux branches guidantes et aux entrées et sortie. Ces régions présentent la même structure verticale. Elles comportent notamment une couche active configurée sous la forme d'un guide d'onde actif 20 qui est confiné entre des couches tampon inférieure et supérieure. Les régions du composant se différencient simplement par le fait qu'elles comportent chacune une électrode inférieure et une électrode supérieure. Les électrodes supérieures de chaque région 1, 2, 3, 4 et 5 sont référencées respectivement E₁, E₂, E₃, E₄ et E₅ sur la figure 1. Les électrodes de ces régions sont indépendantes. Elles sont polarisées et permettent d'injecter une certaine valeur de densité de courant, encore dénommée courant électrique transversal de pompage, à travers la couche active constituant le guide d'onde 20. La valeur des courants de pompage injectés sur chaque électrode indépendante peut être différente, et la densité de porteurs circulant dans la région du guide d'onde 20 située sous chaque électrode, peut également être différente.

Dans la pratique, on a pu constater que les proportions entre les densités de courant circulant dans les régions respectivement de la branche guidante 1, de l'entrée 5 et de la sortie 3, du guide d'onde 20, restent toujours sensiblement identiques, pour des dimensions données du guide. A titre d'exemple indicatif, le rapport entre les courants injectés dans les différentes régions est tel que le courant est plus faible en entrée 5 et en sortie 3 du composant (par exemple de l'ordre de 40 à 60mA) par rapport à la branche guidante 1 (dans laquelle il est par exemple de l'ordre de 180 à 200 mA).

Pour réaliser un convertisseur de longueur d'onde tout actif avec un nombre réduit d'électrodes indépendantes, l'invention propose par exemple de relier les trois électrodes E₁, E₅, et E₃ recouvrant ces trois régions 1, 5, et 3. Bien sûr, étant donné que le composant est symétrique, on pourra également, dans une variante, relier les électrodes E₂, E₅ et E₃ recouvrant respectivement la deuxième branche guidante 2, l'entrée 5 et la sortie 3.

Cependant, en reliant ces trois électrodes en une seule électrode commune, il faut veiller à conserver les proportions entre les densités de porteurs circulant dans les différentes régions recouvertes. Les deux autres électrodes E₂ (ou E₁ selon la variante) et E₄ sont, quant à elles, conservées indépendantes pour permettre d'assurer un contrôle sur le fonctionnement du composant.

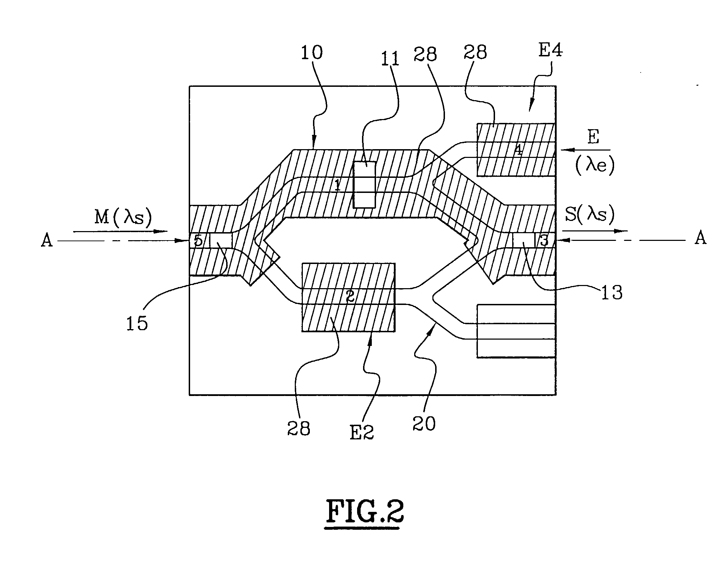

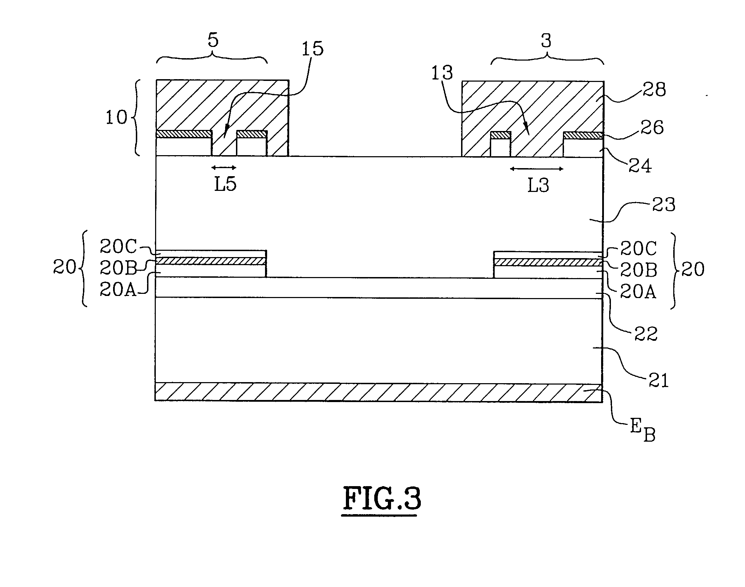

Un exemple de convertisseur de longueur d'onde tout actif réalisé selon la présente invention sera mieux compris au regard des figures 2 et 3 qui le schématisent respectivement en vue de dessus et en coupe longitudinale selon A-A.

Le convertisseur selon l'invention comporte trois électrodes indépendantes, au lieu de cinq dans l'art antérieur. Une de ces électrodes, référencée 10 sur la figure 2 et dénommée dans la suite électrode commune, recouvre notamment les trois régions correspondant à la branche guidante 1, l'entrée 5 et la sortie 3. Elle est en outre réalisée de telle sorte qu'elle présente une résistivité transversale distribuée qui est ajustée selon la région considérée. Le fait d'ajuster la résistivité transversale dans les différentes régions permet, pour une tension appliquée donnée, de modifier la valeur de la densité de courant dans chacune de ces régions. Par conséquent, un ajustement de la résistivité transversale dans différentes zones de l'électrode commune 10, correspondant aux différentes régions recouvertes, permet de conserver les proportions entre les densités de courant circulant dans lesdites régions du guide d'onde actif 20.

La figure 3, qui représente une vue en coupe longitudinale selon A-A du composant de la figure 2, illustre plus en détail la structure verticale du composant ainsi que la manière dont l'électrode commune 10 recouvrant les régions 1, 5 et 3 est réalisée.

De façon classique, la structure de ce convertisseur est constituée successivement, de bas en haut, d'électrodes inférieures, d'un substrat 21, d'une couche tampon inférieure 22, d'une couche active 20, d'une couche tampon supérieure 23, et d'électrodes supérieures. Sur la figure 3, seule la grande électrode 10 commune aux trois régions recouvertes est visible, ainsi qu'une grande électrode inférieure E_{B}, opposée à l'électrode commune 10. De plus, seules deux des régions recouvertes 3 et 5 par l'électrode commune 10 sont visibles sur cette figure 3.

L'empilement, sur le substrat 21, des différentes couches 22, 20, 23 et 24 est réalisé par un procédé d'épitaxie bien connu, comme par exemple un procédé d'épitaxie par jets moléculaires ("MBE").

Le composant optique peut être réalisé sur un substrat 21 en matériau de type III-V, comme par exemple du phosphure d'indium InP avec une structure de guide enterré.

Le substrat est en outre dopé en porteurs d'un premier type, par exemple en porteurs de type n. La couche tampon inférieure 22 peut être réalisée en InP et elle est dopée en porteurs du premier type (en porteurs de type n dans l'exemple).

Le guide enterré 20 peut par exemple comporter successivement:
- une couche de confinement inférieure 20A quaternaire InGaAsP non dopée dont la composition est choisie pour présenter une longueur d'onde caractéristique (longueur d'onde de gap) égale à 1,18µm,
- une couche active 20B quaternaire InGaAsP non dopée dont la composition est choisie pour présenter une longueur d'onde caractéristique (longueur d'onde de gap) égale à 1,55µm,
- une couche de confinement 20C quaternaire InGaAsP non dopée dont la composition est choisie pour présenter une longueur d'onde caractéristique (longueur d'onde de gap) égale à 1,18µm.

La couche tampon supérieure 23 est réalisée dans le même matériau que la couche tampon inférieure 22, c'est à dire en InP dans l'exemple, et elle est dopée en porteurs d'un deuxième type (c'est à dire en porteurs p dans l'exemple).

Le guide actif enterré 20 a par exemple une largeur de 1,2µm de façon à assurer un fonctionnement monomode pour les longueurs d'onde usuelles en communications optiques.

Les électrodes supérieures sont constituées, d'une manière classique, d'une couche de contact 24 sur laquelle est déposée au moins une couche de métallisation 28. La couche de contact 24 est par exemple réalisée dans un matériau ternaire, tel que InGaAs, et fortement dopée en porteurs du deuxième type (c'est à dire en porteurs de type p dans l'exemple). Cette couche de contact 24 est déposée sur toute la surface du composant optique.

Après avoir déposé cette couche de contact 24, on forme, sur celle-ci, un masque métallique 26, constitué de titane ou de tungstène par exemple, en utilisant un procédé classique quelconque bien connu de l'homme de l'art. Ce masque 26 est défini non seulement pour permettre la réalisation des différentes électrodes indépendantes nécessaires au fonctionnement du composant, mais aussi pour permettre de réaliser l'ajustement de la résistivité transversale dans différentes zones de l'électrode commune 10. La couche de contact est donc gravée à travers le masque métallique 26 afin d'obtenir des plots de contact séparés par des zones de gravures. Certains de ces plots définissent les plots de contact des électrodes de contrôle E₂ et E₄ (figure 2), alors que d'autres plots permettent d'assurer l'ajustement de la résistivité transversale dans différentes zones de l'électrode commune 10. Le procédé de gravure utilisé est par exemple un procédé de gravure par ions réactifs ("RIE"). Un recuit éventuel (à 550°C dans le cas d'un substrat en InP par exemple) permet ensuite de diminuer la résistivité à la frontière entre la couche de contact 24 et le métal du masque 26.

Enfin, après avoir réalisé un autre masque, selon un procédé classique et bien connu de l'homme de l'art, on dépose une couche de métallisation 28 pour définir les différentes électrodes 10, E₂ et E₄ du composant. Cette deuxième couche de métallisation 28 est par exemple constituée d'une succession de couches de titane, de platine et d'or, déposées par un procédé connu d'évaporation sous vide. La couche de métallisation 28 de l'électrode commune 10 forme avantageusement un point de contact unique sur cette électrode.

La résistivité transversale de l'électrode commune 10 est ajustée dans différentes zones correspondant respectivement aux régions 1, 3 et 5 recouvertes, grâce à la présence des interruptions locales de la couche de contact 24. Ces interruptions locales sont référencées 11, 13 et 15 sur les figures 2 et 3. Elles sont en outre réalisées sur une largeur au moins identique à celle du guide d'onde actif 20.

Sur les figures 2 et 3, seule une interruption locale 11, 13 et 15 a été représentée respectivement dans chaque région 1, 3 et 5. Cependant, on peut très bien envisager de réaliser aucune ou alors plus d'une interruption locale au-dessus d'au moins une région particulière.

Dans une variante, on peut également graver localement la deuxième couche de métallisation 28 sur une largeur au moins identique à celle du guide d'onde, mais inférieure à celle de l'électrode 10 afin de conserver un point de contact unique. Ces interruptions de la métallisation 28 dans les différentes zones de l'électrode commune 10 sont schématisées sur la figure 2 et également référencées 11, 13 et 15.

Le fait de graver localement la couche métallique 28 ainsi que la couche de contact 24 de l'électrode commune 10, permet d'augmenter la résistivité dans les zones situées sous les interruptions 11, 13, 15.

Ces interruptions locales de la couche de contact 24 et, éventuellement, de la couche de métallisation 28 sont réalisées sur des longueurs L₃, L₅ (figure 3) qui peuvent être déterminées par l'homme du métier, selon les valeurs de la densité de courant qu'il souhaite obtenir dans les régions correspondantes du guide d'onde 20.

Dans une autre variante de réalisation, la résistivité transversale de l'électrode commune 10 peut être ajustée localement, dans les zones correspondant aux régions recouvertes, en modifiant localement le dopage de la couche de contact 24. On rappelle que dans cet exemple, la couche de contact est dopée en porteurs de type p. La modification locale du dopage de cette couche de contact 24 peut être réalisée par exemple au moyen d'un procédé d'implantation ionique. Elle est également réalisée sur une largeur au moins identique à celle du guide d'onde 20 et sur une longueur qui sera déterminée par l'homme du métier en fonction de la densité de courant qu'il souhaite obtenir dans la région considérée.

Les deux autres électrodes indépendantes E₄ et E₂ (figure 2), situées respectivement sur une région 4 d'entrée et sur une région 2 correspondant à la deuxième branche guidante du composant, permettent d'assurer un contrôle sur le fonctionnement de ce composant. L'électrode E₄, de l'amplificateur d'entrée SOA₄, permet notamment d'assurer le contrôle de l'amplification du signal d'entrée E. L'électrode E₂, quant à elle, permet de rectifier le niveau d'amplification dans la deuxième branche par rapport au niveau d'amplification dans la première branche guidante, afin de conserver sensiblement le même niveau d'amplification dans les deux branches de la structure.

La couche de métallisation 28 formant le point de contact unique de l'électrode commune 10 aux trois régions 1, 3 et 5, permet d'injecter un courant issu d'une seule source de courant. La densité de courant circulant dans le guide d'onde 20 situé sous cette électrode commune est ensuite modifiée, selon les régions du guide d'onde, grâce au fait que la valeur de la résistivité transversale de cette électrode est ajustée localement, selon lesdites régions considérées. Cette manière de réaliser un convertisseur de longueur d'onde permet ainsi de respecter les proportions entre les densités de courant circulant dans les différentes régions du guide d'onde 20. La densité de courant, dans ce type de composant, doit en effet être plus faible dans les régions 5 et 3, situées en entrée et en sortie, par rapport à la région de la branche guidante 1. Le nombre d'électrodes indépendantes est ainsi réduit, mais le fonctionnement reste identique à celui des convertisseurs classiques de longueur d'onde tout actif.

L'invention ne s'applique pas seulement aux convertisseurs de longueurs d'onde tout actif. D'une manière générale, elle s'applique à tous les composants optiques tout actif à base de plusieurs amplificateurs optiques à semi-conducteur.

L'invention peut également s'appliquer aux composants à structure active-passive, bien que ce cas soit plus rare. En effet, dans ce cas, la plupart des amplificateurs optiques à semi-conducteur utilisés sont nécessaires pour contrôler le fonctionnement du composant et ne peuvent donc pas être reliés.

Grâce à l'invention, il est donc possible de réduire le nombre d'électrodes indépendantes dans un composant optique tout actif. Cette réduction du nombre d'électrodes entraîne une réduction du nombre de sources de courant nécessaires pour faire fonctionner le composant et, par conséquent, une réduction de coût. L'utilisation d'un tel composant optique et son insertion dans un système optique de télécommunications s'en trouvent donc facilitées. De plus, l'invention n'implique pas d'étape supplémentaire dans le procédé de fabrication, car les interruptions locales dans l'électrode commune peuvent être réalisées par gravure, au moment de la configuration des électrodes supérieures.

## Revendications

1. Composant optique à semi-conducteur, comportant différentes régions (1, 2, 3, 4, 5) ayant la même structure verticale, dans laquelle un guide d'onde actif (20) est enterré entre des couches tampon inférieure (22) et supérieure (23), lesdites régions comportant des électrodes inférieure et supérieure (10, E₂, E₄) afin d'y injecter des valeurs de densité de courant égales ou différentes, caractérisé en ce qu'au moins une (10) desdites électrodes recouvre plusieurs régions (1, 3, 5) et présente une résistivité transversale distribuée qui est ajustée selon la région considérée.

2. Composant selon la revendication 1, caractérisé en ce que les électrodes supérieures (10, E₂, E₄) sont constituées d'une couche de contact (24) sur laquelle est déposée une couche de métallisation (28), et en ce que la résistivité transversale de l'électrode (10) commune à plusieurs régions (1, 3, 5) est ajustée, selon la région considérée, en interrompant localement la couche de contact (24).

3. Composant selon la revendication 2, caractérisé en ce que les interruptions locales (11, 13, 15) de la couche de contact (24) sont réalisées par gravure, sur une largeur au moins identique à celle du guide d'onde actif (20).

4. Composant selon l'une des revendications 1 à 3, caractérisé en ce que la couche de métallisation (28) de l'électrode commune (10) est en outre interrompue localement, par gravure (11, 13, 15), sur une largeur au moins identique à celle du guide d'onde actif (20) et inférieure à celle de ladite électrode (10) commune.

5. Composant selon la revendication 1, caractérisé en ce que les électrodes supérieures (10, E₂, E₄) sont constituées d'une couche de contact (24) dopée, sur laquelle est déposée une couche de métallisation (28), et en ce que la résistivité transversale de l'électrode (10) commune à plusieurs régions (1, 3, 5) est ajustée, selon la région considérée, en modifiant localement le dopage de la couche de contact (24).

6. Composant selon la revendication 5, caractérisé en ce que le dopage de la couche de contact (24) est localement modifié par implantation ionique, sur une largeur au moins identique à celle du guide d'onde actif (20).

7. Composant selon l'une des revendications précédentes, caractérisé en ce qu'il constitue un convertisseur de longueur d'onde tout actif.

8. Composant selon la revendication 7, caractérisé en ce qu'il comporte une électrode (10) commune à une branche guidante (1), à une entrée (5) et à une sortie (3); et deux électrodes (E₂, E₄) de contrôle recouvrant respectivement une autre branche guidante (2) et une autre entrée (4).
